(19) **Europäisches Patentamt European Patent Office Office européen des brevets**

(11) **EP 3 338 103 B1**

(12) **EUROPEAN PATENT SPECIFICATION**

(45) Date of publication and mention
of the grant of the patent:
**20.03.2024 Bulletin 2024/12**

(21) Application number: **16748038.3**

(22) Date of filing: **01.08.2016**

(51) International Patent Classification (IPC):
*G01R 33/07* (2006.01)   *G01R 33/00* (2006.01)
*G01R 33/12* (2006.01)

(52) Cooperative Patent Classification (CPC):
**G01R 33/07; G01R 33/0023; G01R 33/1215**

(86) International application number:
**PCT/US2016/044957**

(87) International publication number:
**WO 2017/030772 (23.02.2017 Gazette 2017/08)**

(54) **MAGNETIC FIELD SENSOR TO DETECT A MAGNITUDE OF A MAGNETIC FIELD IN ANY DIRECTION**

MAGNETFELDSENSOR ZUR ERFASSUNG EINER GRÖSSE EINES MAGNETFELDES IN JEDER RICHTUNG

CAPTEUR DE CHAMP MAGNÉTIQUE POUR DÉTECTER UNE INTENSITÉ D'UN CHAMP MAGNÉTIQUE DANS N'IMPORTE QUELLE DIRECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.08.2015 US 201514830098**

(43) Date of publication of application:
**27.06.2018 Bulletin 2018/26**

(73) Proprietor: **Allegro MicroSystems, LLC
Manchester, NH 03103-3353 (US)**

(72) Inventors:
• **JUDKINS, Joseph James III**
  **Bedford, New Hampshire 03110 (US)**
• **METIVIER, Ryan Jon**
  **Nashua, New Hampshire 03062 (US)**
• **MONREAL, Gerardo A.**
  **Pilar 1631 (AR)**
• **UBERTI, Bruno Luis**
  **Ciudad de Buenos Aires 1425 (AR)**

(74) Representative: **South, Nicholas Geoffrey et al
AA Thornton IP LLP
8th Floor, 125 Old Broad Street
London EC2N 1AR (GB)**

(56) References cited:
**KR-A- 20060 085 570    US-A1- 2011 031 968
US-A1- 2014 009 144    US-A1- 2014 239 942
US-A1- 2014 347 044**

• **SANDER CHRISTIAN ET AL: "Isotropic 3D silicon hall sensor", 2015 28TH IEEE INTERNATIONAL CONFERENCE ON MICRO ELECTRO MECHANICAL SYSTEMS (MEMS), IEEE, 18 January 2015 (2015-01-18), pages 893-896, XP032740980, DOI: 10.1109/MEMSYS.2015.7051103 [retrieved on 2015-02-26]**

**EP 3 338 103 B1**

**Description**

**CROSS REFERENCE TO RELATED APPLICATIONS**

This application is a continuation-in-part of application of U.S. Patent Application Serial Number 14/277,218, filed May 14, 2014, entitled "MAGNETIC FIELD SENSOR FOR DETECTING A MAGNETIC FIELD IN ANY DIRECTION," which claims the benefit under 35 U.S.C. §119(e) of U.S. Provisional Application No. 61/827,280 filed May 24, 2013.

**BACKGROUND**

As is known, there are a variety of types of magnetic field sensing elements, including, but not limited to, Hall Effect elements, magnetoresistance elements, and magnetotransistors. As is also known, there are different types of Hall Effect elements, for example, planar Hall elements, vertical Hall elements, and circular Hall elements. As is also known, there are different types of magnetoresistance elements, for example, anisotropic magnetoresistance (AMR) elements, giant magnetoresistance (GMR) elements, tunneling magnetoresistance (TMR) elements, Indium antimonide (InSb) elements, and magnetic tunnel junction (MTJ) elements.

Hall Effect elements generate an output voltage proportional to a magnetic field. In contrast, magnetoresistance elements change resistance in proportion to a magnetic field. In a circuit, an electrical current can be directed through the magnetoresistance element, thereby generating a voltage output signal proportional to the magnetic field.

Magnetic field sensors, which use magnetic field sensing elements, are used in a variety of applications, including, but not limited to, a current sensor that senses a magnetic field generated by a current carried by a current-carrying conductor, a magnetic switch (also referred to herein as a proximity detector) that senses the proximity of a ferromagnetic or magnetic object, a rotation detector that senses passing ferromagnetic articles, for example, gear teeth, and a magnetic field sensor that senses a magnetic field density of a magnetic field. Magnetic switches are used as examples herein. However, the circuits and techniques described herein apply also to any magnetic field sensor.

Conventional magnetic switches can sense a magnetic field above a threshold level in one dimension, i.e., along a line. Some conventional magnetic switches can sense a magnetic field above a threshold in two dimensions, i.e., in a plane. Documents US2011/031968A1 and US2014/347044A1 disclose related magnetic field sensors configured to determine vector components of a magnetic field.

**SUMMARY**

In one aspect, a magnetic field sensor includes the features of appended claim 1.

The preceding aspect may include one or more of the features as defined in the corresponding dependent claims.

A method includes the steps as defined in appended claim 13.

**BRIEF DESCRIPTION OF THE DRAWINGS**

The foregoing features of the invention, as well as the invention itself may be more fully understood from the following detailed description of the drawings, in which:

FIG. 1 is a pictorial showing an integrated circuit having a magnetic field sensor therein disposed upon a substrate, and showing three coordinate axes;

FIG. 2, which includes FIGS. 2A, 2B, and 2C in combination, is a block diagram showing an exemplary magnetic field sensor, in the form of a magnetic switch, which can be used as the magnetic field sensor of FIG. 1, which has a planar Hall element and two vertical Hall elements, and which has a so-called omni comparator;

FIG. 3 is a graph showing three exemplary clock signals that can be used within the magnetic field sensor of FIG. 2;

FIG. 4 is a block diagram of an exemplary omni comparator that can be used as the omni comparator of FIG. 2;

FIG. 5 is a block diagram of an exemplary transfer function that describes function of the omni comparator of FIG. 4;

FIG. 6 is a pictorial showing three-dimensional operating point thresholds (BOP) and three-dimensional release point thresholds (BRP);

FIG. 7 is a block diagram showing a wired or gate structure that can be used in conjunction with the magnetic field sensor of FIG. 2;

FIG. 8, which includes FIGS. 8A, 8B, and 8C in combination, is a block diagram of another exemplary magnetic field sensor, in the form of a magnetic switch, which can be used as the magnetic field sensor of FIG. 1, and which has a planar Hall element and two magnetoresistance element circuits;

FIG. 9 is a block diagram of an exemplary magnetoresistance element circuit that can be used as the magnetoresistance element circuits of FIG. 8;

FIG. 10 is a block diagram of an alternate embodiment of power and clocking portions that can be used in the magnetic field sensors of FIGS. 2 and 8;

FIG. 11 is a block diagram of another alternate embodiment of power and clocking portions that can be used in the magnetic field sensors of FIGS. 2 and 8;

FIG. 12 is a block diagram of another example of a magnetic field sensor, in the form of a magnetic switch, which can be used as the magnetic field sensor of FIG. 1, which has a planar Hall element and two vertical Hall elements;

FIG. 13 is a flowchart of an example of a process to determine if a magnitude of a magnetic field is greater than a threshold voltage; and

FIG. 14 is a simplified block diagram of an example of a computing device on which any portion of the process of FIG. 13 may be implemented.

## DETAILED DESCRIPTION

As used herein, the term "magnetic field sensing element" is used to describe a variety of electronic elements that can sense a magnetic field. The magnetic field sensing element can be, but is not limited to, a Hall Effect element, a magnetoresistance element, or a magnetotransistor. As is known, there are different types of Hall Effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

As is known, some of the above-described magnetic field sensing elements tend to have an axis of maximum sensitivity in the plane of a substrate that supports the magnetic field sensing element, and others of the above-described magnetic field sensing elements tend to have an axis of maximum sensitivity normal to a substrate that supports the magnetic field sensing element. In particular, planar Hall elements tend to have axes of sensitivity normal to a substrate, while metal based or metallic magnetoresistance elements (e.g., GMR, TMR, AMR) and vertical Hall elements tend to have axes of sensitivity in the plane of the substrate.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

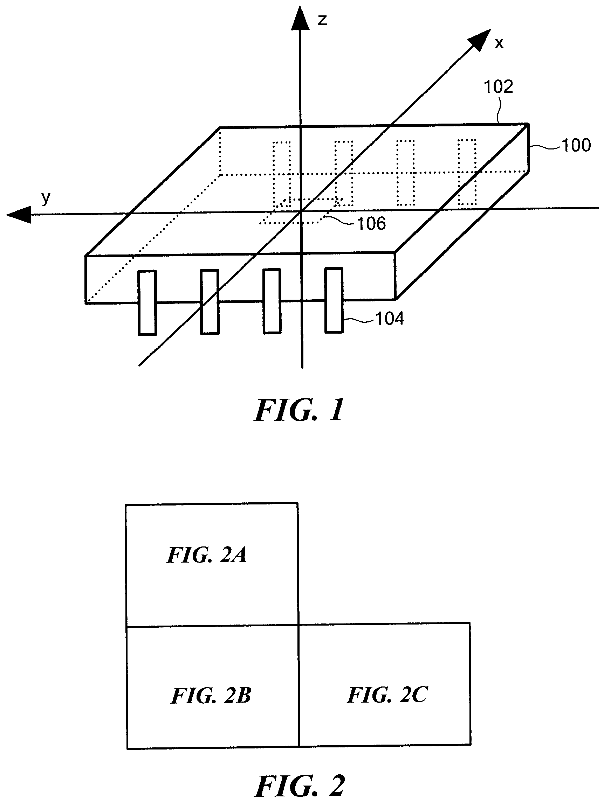

Referring to FIG. 1, an exemplary integrated circuit 100 includes a housing 102, for example, a plastic housing, a plurality of leads, of which a lead 104 is one example, and an integrated circuit substrate 106, for example, a semiconductor substrate upon which a magnetic field sensor can be disposed.

An x, y, z Cartesian coordinate system is shown and will be referenced in figures that follow.

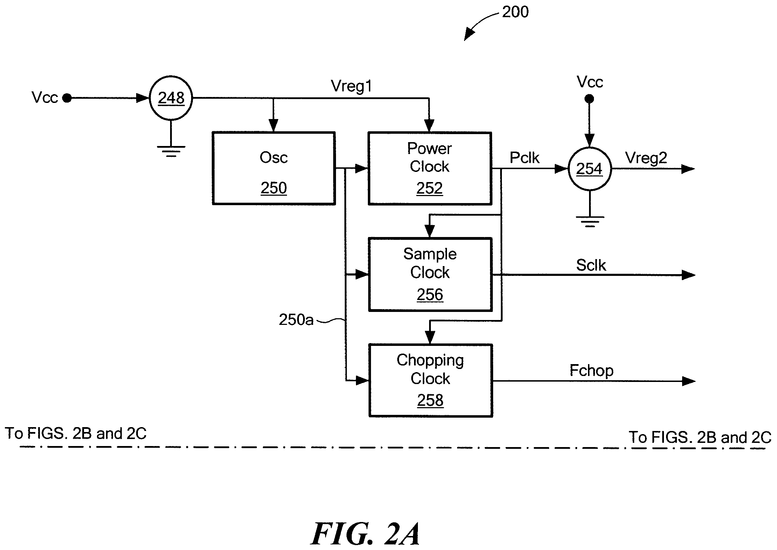

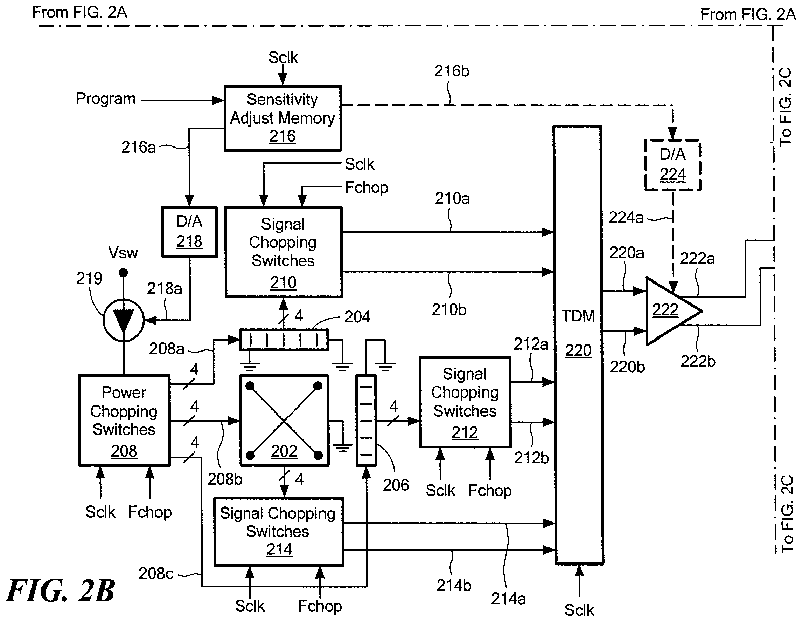

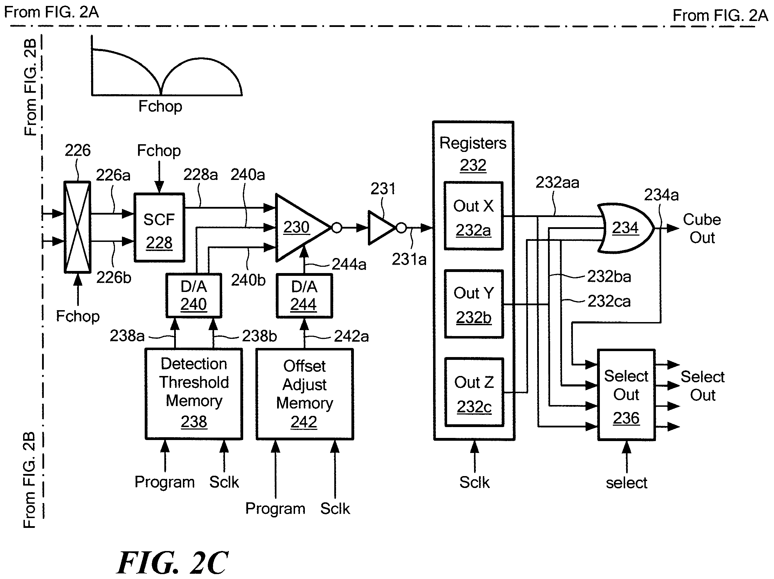

Referring now to FIG. 2, an exemplary magnetic field sensor 200, in the form of magnetic switch, includes a planar (or horizontal) Hall element 202, which has a maximum response axis directed out of the page. The magnetic field sensor 200 also includes a first vertical Hall element 204 with a maximum response axis directed up and down on the page when the page is held in landscape mode. The magnetic field sensor 200 also includes a second vertical Hall element 206 with a maximum response axis directed right to left on the page when the page is held in landscape mode.

It is intended that the maximum response axis of the planar Hall element 202 points in the direction of the z-axis of FIG. 1. It is intended that the maximum response axis of the first vertical Hall element 204 points in the direction of the x-axis of FIG. 1. It is further intended that the maximum response axis of the second vertical Hall element 206 points in the direction of the y-axis of FIG. 1.

While orthogonal Cartesian coordinates are shown and described herein, it should be appreciated that orientations of the maximum response axes of the planar Hall element 202, the first vertical Hall element 204, and the second vertical Hall element 206 need not point in orthogonal directions. Orthogonal directions are merely used as an example herein.

It is known that Hall elements tend to generate an output voltage signal that has both a magnetically responsive signal portion and an unwanted DC offset signal portion. Current spinning (also referred to as chopping) is a known technique used to reduce the offset signal portion. Chopping can be applied to both planar Hall elements and vertical Hall elements. With chopping, selected drive and signal contact pairs are interchanged during each phase of the chopping.

Chopping tends to result in a frequency domain separation of the magnetically responsive signal portion of an output signal from a Hall element with respect to the offset signal portion of the output signal from the Hall element. In so-called "signal modulation," the magnetically responsive signal portion is shifted to a higher frequency and the offset signal portion remains at baseband. In so-called "offset modulation," the offset signal portion is shifted to a higher frequency and the magnetically responsive signal portion remains at baseband. For a planar Hall element, these two types of chopping are described, for example, in U.S. Patent application no. 13/095,371, filed April 27, 2011, entitled "Circuits and Methods for Self-Calibrating or Self-Testing a Magnetic Field Sensor." For a vertical Hall element, chopping is described in U.S. Patent application no. 13/766,341, filed February 13, 2013, entitled "MAGNETIC FIELD SENSOR AND RELATED TECHNIQUES THAT PROVIDE VARYING CURRENT SPINNING PHASE SEQUENCES OF A MAGNETIC FIELD SENSING ELEMENT."

The signal modulation type chopping is described in figures herein. However, in other embodiments, the offset modulation type of chopping can be used.

Furthermore, magnetic field sensor are shown herein that employ chopping arrangements, in other embodiments, no chopping is used,

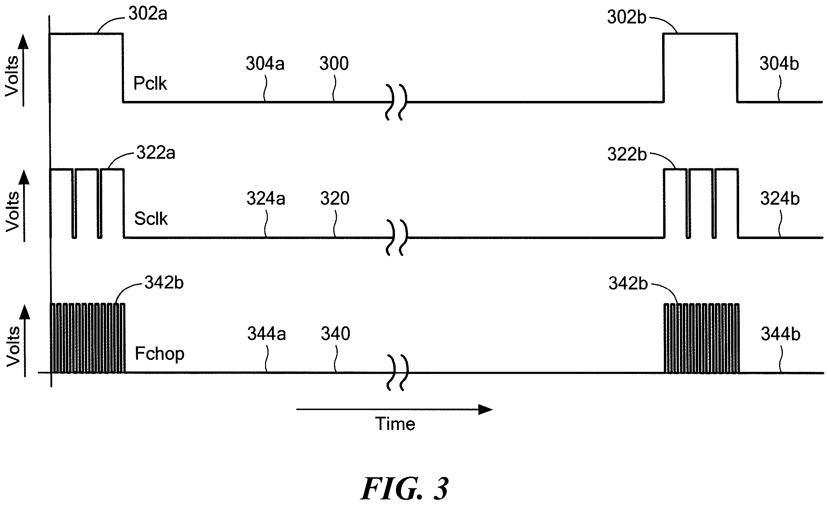

In accordance with the above-described chopping, power chopping switches 208 apply chopped drive signals 208b to the planar Hall element 202, chopped drive signals 208a to the first vertical Hall element 204, and chopped drive signals 208c to the second vertical Hall element 206. The chopped drive signals change phases at a rate determined by a clock signal with a frequency, Fchop. The power chopping switches 208 also receive the sample clock, Sclk, signal. It will become apparent from discussion below in conjunction with FIG. 3 that the power chopping switches can decode the sample clock, Sclk, and can apply the chopped drive signals 208a, 208b, 208c sequentially and one at a time so that only one of the three Hall elements is operational at a time.

Also in accordance with the above-described chopping, signal chopping switches 214 select signal contacts of the planar Hall element 202, signal chopping switches 210 select signal contacts of the first vertical Hall element 204, and signal chopping switches 212 select signal contacts of the second vertical Hall element 212. As described in further detail below, the chopping, and operation of the planar Hall element 202, the first vertical Hall element 204, and the second vertical Hall element 206 occur from time to time in accordance with the sample clock, Sclk, received by the power chopping switches 208 and by the various signal chopping switches 210, 212, 214.

The signal chopping switches 210, 212, 214 are also coupled to receive the chopping frequency clock, Fchop, described more fully below.

A time division multiplex module 220 is coupled to receive three different differential signals 210a, 210b, and 212a, 212b, and 214a, 214b from the signal chopping switches 210, 212, 214. The time division multiplex module 220 is also coupled to receive the sample clock, Sclk. It will be appreciated that the three differential signals 210a, 210b, and 212a, 212b, and 214a, 214b are chopped signals, for which the magnetically responsive signal portion can be shifted to a higher frequency in accordance with the chopping frequency, Fchop. The unwanted offset signal portion remains at baseband within the three differential signals 210a, 210b, and 212a, 212b, and 214a, 214b.

While differential signals are described above and below, it will be appreciated that, in other embodiments, similar circuits can be designed that use single ended signals.

The time division multiplex module 220 is configured to sequentially select from among the three different differential signals 210a, 210b, and 212a, 212b, and 214a, 214b and to provide a differential sequential signal at an output therefrom, which is representative of sequential ones of the three differential signals 210a, 210b, and 212a, 212b, and 214a, 214b received by the time division multiplex module 220.

An amplifier 222 is coupled to receive the differential sequential signal 220a, 220b from the time division multiplex module 220 and is configured to generate a differential amplified signal 222a, 222b.

A modulator 226 is coupled to receive the differential amplified signal 222a, 222b and to generate a differential modulated signal 224a, 224b. The modulator 226 is operable to do another frequency conversion, i.e., to shift a frequency of the magnetically responsive signal portion back to baseband, and to shift the offset signal portion up to higher frequency in accordance with the chopping frequency, Fchop. It should be appreciated that, the modulator 226 also operates to shift an unwanted offset generated by the amplifier 222 up to the higher frequency. Thus, the differential modulated signal 226a, 226b generated by the modulator 226 has unwanted offset signal portions shifted to a higher frequency and the magnetically responsive signal portion, which is desired, is at baseband.

The differential modulated signal 226a, 226b generated by the modulator 226 can be received by a filter, here, a switched capacitor filter 228, which is an analog sampled filter. In some embodiments the switched capacitor filter 228 is a switched capacitor notch filter, which has a transfer function with a first notch at the chopping frequency, Fchop. The filter 228 essentially removes the unwanted offset signal portion that occurs in the differential modulated signal 226a, 226b at the frequency, Fchop.

An exemplary switched capacitor notch filter is described in U.S. Patent No. 7,990,209, issued August 2, 2011, entitled "SWITCHED CAPACITOR NOTCH FILTER".

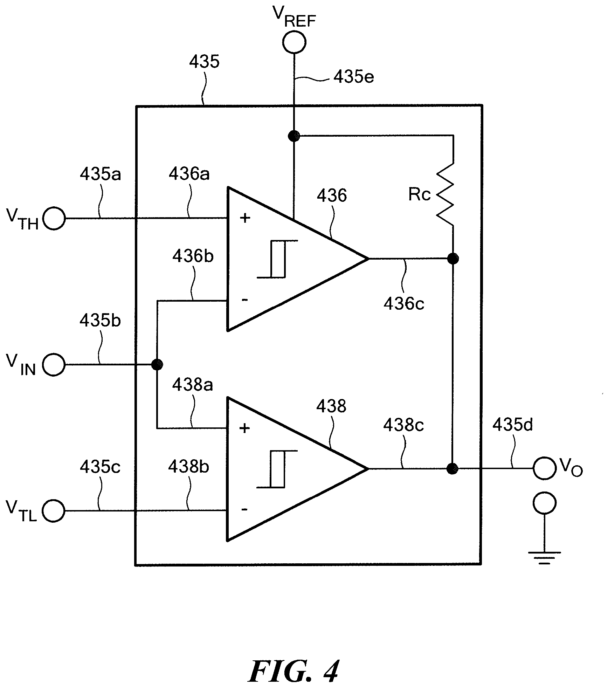

The switched capacitor filter 228 is configured to generate a filtered signal 228a, which is received by a comparator 230, referred to herein as an omni comparator for reasons that will be apparent from discussion below. The omni comparator 230 is described more fully below in conjunction with FIG. 4.

From discussion above, in accordance with a sampling clock signal, Sclk, received by the time division multiplex module 220, it will be apparent that the filtered signal 228a provided by the switched capacitor filter 228 is, at some sequential times, representative of a signal generated by the planar Hall element 202, at some other sequential times representative of a signal generated by the first vertical Hall element 204, and at some other sequential times representative of a signal generated by the second vertical Hall element 206.

The omni comparator 230 is coupled to receive threshold signals 240a, 240b from a digital to analog converter 240. In some embodiments, the threshold signals 240a, 204b can be the same for each one of the sequential signals described above and provided by the switched capacitor filter 228, or different thresholds can be provided for each one of the sequential signals described above and provided by the switched capacitor filter 228.

The comparator 230 is configured to generate a comparison signal received by an inverter 231, which generates an inverted comparison signal 231a received by registers 232.

The registers 232 are also coupled to receive the sample clock signal, Sclk. The registers are operable, by way of decoding the sample clock signal, Sclk, to sequentially store comparison values (e.g., zero or one) corresponding to the comparisons of the sequential signals 228a provided by the switch capacitor filter 228 with appropriate thresholds 240a, 240b. Thus, in some embodiments, a comparison value can be stored in a register 232a that is representative of a sensed magnetic field in an x direction being above a threshold signal, another comparison value can be stored in a register 232b that is representative of the sensed magnetic field in a y direction being above a threshold signal, and another comparison value can be stored in a register 232c that is representative of the sensed magnetic field in a z direction being above a threshold signal. As described above the threshold signals 240a, 240b can be the same or they can be different for each one of the Hall elements.

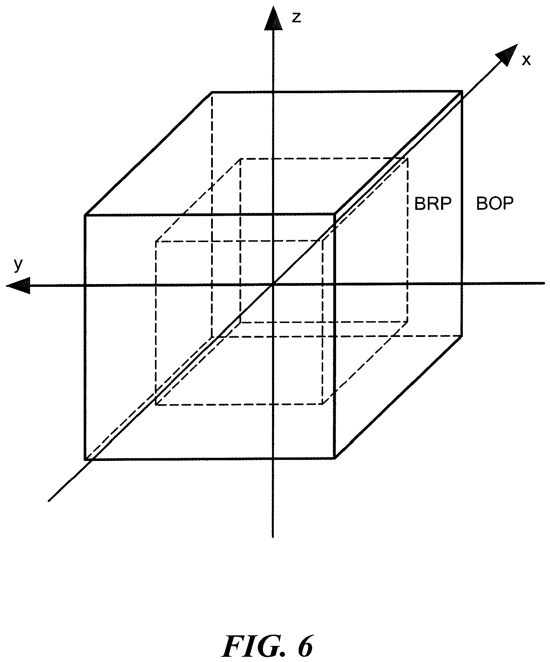

As is described in conjunction with FIG. 4 below, the omni comparator 230 uses the threshold signals 240a, 240b to result in two bidirectional operating point thresholds and two bidirectional release point thresholds. Thus, a first state of the comparison values (e.g., one or high state) can be representative of a sensed magnetic field being greater than a corresponding operating point threshold in one of two parallel directions (e.g., along the x, y, or z axes of FIG. 1) represented by the sample signal 228a. A second different state of the comparison values (e.g., zero or low state) can be representative of the sensed magnetic field being below a corresponding release point threshold in one of the two parallel directions. The thresholds are further described below in conjunction with FIG. 6.

The registers 232 provide output values 232aa, 232ba, 232ca. A logic gate 234 is coupled to receive the output values 232aa, 232ba, 232ca. If any one of the output values 232aa, 232ba, 232ca is indicative of a magnetic field being above an associated operating point threshold in a direction of a corresponding coordinate axis, an output signal 234a changes state.

A select output gate 236 can be coupled to receive the output values 232aa, 232ba, 232ca and also coupled to receive the output signal 234a. By way of a select control signal provided from outside of the magnetic field sensor 200 by a user, the select output gate 236 can provide as an output signal either the output signal 234a, all of the output values 232aa, 232ba, 232ca, or any one or more of the output values 232aa, 232ba, 232ca.

The magnetic field sensor can include one or more of a sensitivity adjust memory 216, a detection threshold memory 238, and an offset adjust memory 242, each of which can be programmed with values by a user via a programs signal from outside of the magnetic field sensor 200. The memories can be non-volatile memories.

The sensitivity adjust memory 216 can provide sequential sensitivity values 216a that can take on three different values determined in accordance with the sample clock signal, Sclk. Thus, the sensitivity adjust memory can provide a sensitivity value 216a that is appropriate for which Hall element is presently powered up in a sequential fashion. A digital-to-analog converter 218 can be coupled to receive the sequential sensitivity values 216a and can provide sequential sensitivity signal 218a.

The power chopping switches 208 can be coupled to receive a signal from a current source 219 as a drive signal. The drive signal can be adjusted to three different values depending upon the three different values of the sequential sensitivity signal 218a. In this way, the planar Hall element 202, the first vertical Hall element 204, and the second vertical Hall element 206 can each be driven with different amounts of drive signal to achieve either different sensitivities to a magnetic field, or preferably, the same sensitivities to the magnetic field.

In an alternate embodiment, the sensitivities of the three Hall elements are instead adjusted by way of sequential sensitivity values 216b coupled to a digital-to-analog converter 224, which sequentially adjusts a gain of the amplifier 222.

The detection threshold memory 238 can be used to store three thresholds (e.g., three symmetrical sets of two thresholds) that can be used to compare with each one of the three sequential signals within the output signal 228a from the switched capacitor filter 228. The three stored threshold can be the same or they can be different. Function of the magnetic field sensor 200 when the thresholds are the same and when the thresholds are different are described below in conjunction with FIG. 6.

The offset adjust memory 242 can be used to store three offset correction values that can be sequentially applied to the omni comparator 230 (or, in other embodiments, to the amplifier 222) in accordance with the three sequential signals within the output signal 228a from the switched capacitor filter 228. It will be recognized that, while chopping is described in conjunction with the magnetic field sensor 200, still some residual DC offset may exist and the offset correction values applied through a digital-to-analog converter 244 to the omni comparator 230 can be used compensate for the residual offsets.

The magnetic field sensor 200 can include a micropower regulator 248 coupled to receive the magnetic field sensor power supply voltage, Vcc, and configured to generate a first regulated voltage , Vreg1, which can continuously power an oscillator 250, a power clock generator 252. The micropower regulator 248, the oscillator 250, the power clock generator 252, the output registers 232, the logic gate 234, and the select output gate 236 can remain powered up by Vreg1 at all times during operation of the magnetic field sensor 200. The oscillator 250 can generate a continuous clock signal 250a, and the power clock generator 252 can generate a continuous power clock signal, Pclk. The various clock signals are described more fully below in conjunction with FIG. 3.

The power clock generator is configured to generate a power clock signal, Pclk received by a second voltage regulator 254 configured to generate a second regulated voltage, Vreg2, which turns on and off in accordance with states of the power clock signal, Pclk. The second regulator voltage, Vreg2, is used to power all portions of the magnetic field sensor except for the oscillator 250, the power clock generator 252, the output registers 232, the logic gate 234 and the select output gate 236. Thus, in operation, substantial portions of the magnetic field sensor 200 power on and off (or to a low power state) at a cycle rate and a duty cycle determined by the power clock signal, Pclk. Essentially, the magnetic field sensor powers up from time to time, senses a magnetic field in the environment, determines if the magnetic field is above operating point thresholds stores such information into the registers 232 and makes available an indication of same at all times. As a result, micropower operation is achieved.

The magnetic field sensor 200 can also include a sample clock module 256 coupled to receive the clock signal 250a and the chopping clock module 258 also coupled to receive the clock signal 250a. The sample clock module 256 and the chopping clock module 258 can also be coupled to receive the power clock signal, Pclk. The sample clock module 256 is configured to generate the sample clock, Sclk. The chopping clock module 258 is configured to generate the chopping clock with a frequency, Fchop.

Referring now to FIG. 3, a signal 300 is representative of the power clock signal, Pclk, of FIG. 2. The power clock signal 300 can have sequential high states 302a, 302b with time durations of Thigh, between which are low states 304a, 304b with time durations of Tlow. From discussion above in conjunction with FIG. 2, it will be appreciated that the majority of the circuits within the magnetic field sensor 200 are powered on during high states of the power clock signal, Pclk, and powered off during the low states of the power clock signal, Pclk. However, it should be recognized that the shorter time duration states can instead be low states and the longer time duration state can instead be a high state without departing from the invention.

In order to achieve micropower operation, in some embodiments, Thigh/(Thigh+Tlow) is less than or equal to 0.001, i.e., the power on duty cycle is less than 0.1 percent. However, in other embodiments, the duty cycle can be in a range of ten percent to 0.001 percent, or any duty cycle less than about ten percent.

In some embodiments, a sample time period, Thigh+Tlow, is about fifty milliseconds. Thus, the three Hall elements of FIG. 2 must be sampled in a time period of about fifty microseconds. However, other sample time periods are also possible in a range of about ten seconds to about ten milliseconds.

The above sample time period of fifty milliseconds is selected in accordance with a bandwidth of a sensed magnetic field. By Nyquist, 1/(sample time period) must be greater than two times the bandwidth of the signal to be sampled. Thus, if the sample time period is fifty milliseconds, the maximum bandwidth of the signal to be sample is ten Hz.

While the above represents a narrow detected bandwidth, the bandwidth of the electronic circuits of the magnetic fields sensor 200 of FIG. 2 must be substantially greater than ten Hz in order to pass the short time duration samples of the three Hall Effect elements. It is known that wider bandwidth results in larger amounts of thermal noise. The thermal noise manifests itself as an apparent shift in the trip points at the omni comparator 230. Thus, in some embodiments, the threshold values stored in the detection threshold memory 238 are adjusted to account for the thermal noise resulting from the wide bandwidth.

A signal 320 is representative of the sample clock signal, Sclk, of FIG. 2. Within each high state of the signal 300, the signal 320 has three high states and two low states 322a, 322b.

Each high state of the signal 320 corresponds to one sample of one of the Hall elements in the magnetic field sensor 200 of FIG. 2. Thus, during a first high state, one of the three Hall elements is sampled and sent through the electronic channel of the magnetic field sensor 200, during a second high state another one of the three Hall elements is sampled and sent through the electronic channel, and during a third high state another one of the three Hall elements is sampled and sent through the electronic channel.

It should be appreciated that the various modules of the magnetic field sensor 200 of FIG. 2 that receive the sample clock signal, Sclk, must decode the sample clock signal. However, in other embodiments, the sample clock signal, Sclk, can be provided as three separate signals, each having one of the high states in sequence.

A signal 340 is representative of the chopping clock signal with the frequency, Fchop of FIG. 2. For four state chopping, there are four or more clock pulses in the signal 340 for each one of the high states 322a of the sample clock signal 320. At other times, the chopping clock signal is inactive, or low.

It will be appreciated that all of the sampling of the Hall elements of FIG. 2, and all of the chopping of the Hall elements, occurs during the high or active state of the power clock signal, Pclk, 300. At other times, most of the magnetic field sensor 200 is powered off.

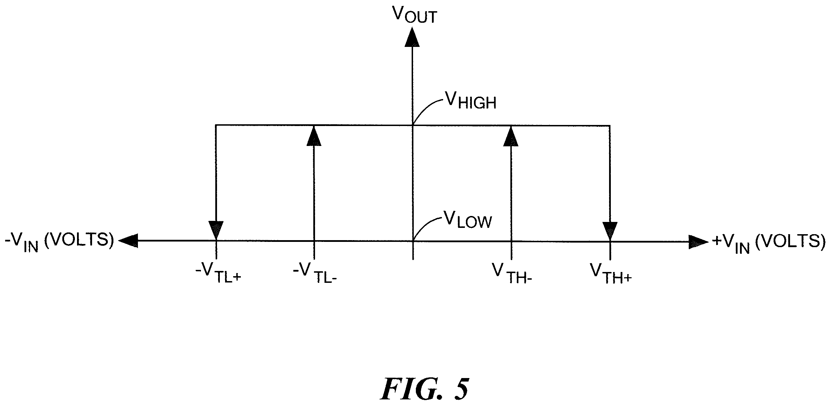

Referring now to FIGS. 4 and 5 together, a comparator circuit 435 can be the same as or similar to the omni comparator 230 of FIG. 2. The comparator circuit 435 has a plurality of terminals, 435a-435e, and includes first and second and comparators 436, 438. The comparator 436 has a first terminal 436a coupled to a first reference voltage $V_{TH}$ at terminal 435a, a second input terminal 436b coupled to an input voltage $V_{IN}$ at terminal 435b and an output terminal 436c coupled to comparator circuit output terminal 435d where an output voltage $V_{OUT}$ is provided. A reference voltage, $V_{REF}$ is coupled to terminal 435e and provides a reference voltage to comparators 436, 438.

Reference is made below to threshold voltages $V_{TH+}$, $V_{TH-}$, $V_{TL+}$, $V_{TL-}$. It will be recognized that the threshold voltages $V_{TH-}$ and $V_{TL+}$ are representative of the above-described operating point thresholds (i.e., threshold signals 240a, 240b of FIG. 2) and the threshold voltages $V_{TH-}$ and $V_{TL-}$ are representative of the above-described release point thresholds, which are a result of hysteresis within the comparator circuit 435.

The comparator 438 includes a first input terminal 438a coupled at input port 435b to the input voltage $V_{IN}$ and a second input terminal, 438b, coupled to a threshold voltage $V_{TL}$ at terminal 435c. An output terminal 438c of comparator 438 is coupled to provide the output voltage $V_{OUT}$ at the output terminal 435d.

In this particular embodiment, comparators 436, 438 are provided having a means for including hysteresis such that the reference or threshold voltages $V_{TH}$, $V_{TL}$ can be represented as $V_{TH+}$ and $V_{TH-}$ and $V_{TL+}$ and $V_{TL-}$, respectively. The values $V_{TH+}$, $V_{TH-}$, $V_{TL+}$, $V_{TL-}$ represent the comparator switch points depending upon the value of the output voltage $V_{OUT}$. In operation, and as seen in FIG. 5, once the output voltage $V_{OUT}$ switches (e.g. from a high level to a low level), then the switch point changes from $V_{TH+}$ to $V_{TH-}$. Likewise, once the output voltage $V_{OUT}$ switches from a low level to a high level, then the switch point changes from $V_{TH-}$ to $V_{TH+}$

As can be seen in FIG. 5, the same holds true as the input voltage $V_{IN}$ assumes negative voltages (i.e., voltage values on the left hand side of the Vout-axis in FIG. 5). That is, once the output voltage $V_{OUT}$ switches then the switch point changes from $-V_{TL+}$ to $-V_{TL-}$ and vice-versa depending upon whether the output is switching from low to high or from high to low.

If the output voltage $V_{OUT}$ is high and the input voltage $V_{IN}$ has a value greater than or equal to zero, when the input voltage $V_{IN}$ meets or exceeds the voltage $V_{TH+}$, the output voltage switches from a value of $V_{HIGH}$ to $V_{LOW}$ and the switch point changes from $V_{TH+}$ to $V_{TH-}$. Thus the value of the output voltage $V_{OUT}$ will not switch from $V_{LOW}$ to $V_{HIGH}$ until the input voltage $V_{IN}$ reaches the value $V_{TH-}$.

It should be appreciated that, in other embodiments and applications, it may be preferable to utilize comparators which do not have hysteresis and thus switching occurs at a single voltage level, e.g., $V_{TH+}$ and $-V_{TL+}$, i.e., only operating point thresholds are used.

With reference to only one of the Hall elements of FIG, 2, and to one corresponding directional axis of FIG. 1, in operation, and with reference now to FIG. 5, the input voltage $V_{IN}$ is generated in response to a magnetic field being provided to and removed from a magnetic field sensing device which senses the magnetic field and provides a corresponding signal in response thereto.

Assuming the input voltage $V_{IN}$ is at or near zero volts (i.e. $V_{IN}$ = 0 volts), the output voltage $V_{OUT}$ is at a first predetermined voltage level $V_{HIGH}$. In response to a magnetic field, the Hall element (e.g., 202, 204, 206 of FIG. 1) that causes the input voltage provides either a positive or a negative input voltage $V_{IN}$. If the input voltage provided by the Hall element moves in a positive direction from zero volts toward the threshold voltage, $V_{TH+}$, when the threshold voltage meets and/or exceeds the threshold voltage level $V_{TH+}$, then the output voltage $V_{OUT}$ changes from the predetermined signal level, $V_{HIGH}$ to a second predetermined voltage level $V_{LOW}$. When the input voltage moves past the threshold voltage $V_{TH-}$ in a negative-going direction, the output voltage changes from $V_{LOW}$ back to $V_{HIGH}$.

Likewise, as the input voltage moves in a negative direction from zero volts and reaches and/or exceeds the threshold voltage $-V_{TL+}$, the output voltage $V_{OUT}$ changes from the first value $V_{HIGH}$ to the second value $V_{LOW}$. Similarly, as the input voltage $V_{IN}$ moves from $-V_{TL+}$ and reaches and/or exceeds the voltage level $-V_{TL-}$, the voltage level then changes from the output voltage level $V_{LOW}$ to $V_{HIGH}$.

While the graph of FIG. 5 is representative of a particular polarity of output signal from the comparator circuit 435, it should be recognized that a similar circuit can generate the opposite polarity.

Referring now to FIG. 6, a graph has x, y, and z axes representative of the same axes in FIG. 1. The axes are each indicative of magnetic field strengths. An outer box is representative of the operating point thresholds (BOP) in three dimensions corresponding to the three dimensions of the Hall elements 202, 204, 206 of FIG. 2. An inner box is representative of the release point thresholds (BRP) in three dimensions corresponding to the three dimensions of the Hall elements.

In operation of the magnetic field sensor 200 of FIG. 2, it should be understood that a magnetic field experienced by the magnetic field sensor 200 having any of its Cartesian coordinates on the reference axes described in FIG. 1 is greater in absolute value than the operating point thresholds, i.e., outside of the outer box, results in a change of state of the output signal 234a of the magnetic field sensor 200 to a first state indicative of a detection of the magnetic field. It should also be recognized that a magnetic field experienced by the magnetic field sensor 200 having any of its Cartesian coordinates on the reference axes described in FIG. 1 lower in absolute value than the release point thresholds, i.e., inside of the inner box, results in a change of state of the output signal 234a of the magnetic field sensor 200 to a second different state indicative of a lack of detection of the magnetic field.

In view of the above, the magnetic field sensor 200 operates as a three-dimensional switch operable to detect a magnetic field that can be pointing in any direction with a magnitude that is beyond the outer box.

While square boxes are shown, any one of more dimensions of the two boxes can be reshaped (i.e., to a shape other than a cube) by changing threshold values stored in the detection threshold memory 238 of FIG. 2.

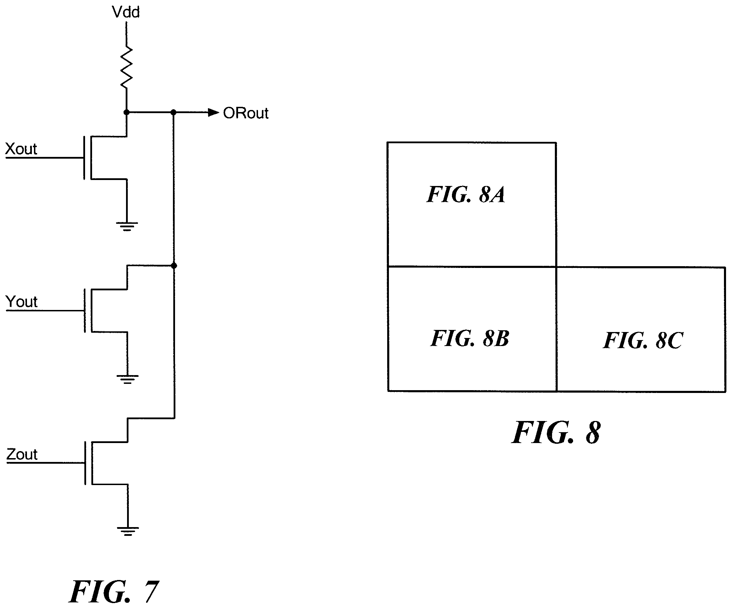

Referring now to FIG. 7, for embodiments in which the output signals 232aa, 232ba, 232ca are provided as output signals by way of the selection output module 236 of FIG. 2, a wired OR function can be brought provided by three FETS, or otherwise, by three transistors, each coupled to a pull-up resistor terminating in a user selectable power supply voltage, Vdd.

An output signal ORout from the wired OR circuit can behave very much like the output signal 234a of FIG. 2, but for which high states are determined by the power supply voltage, Vdd.

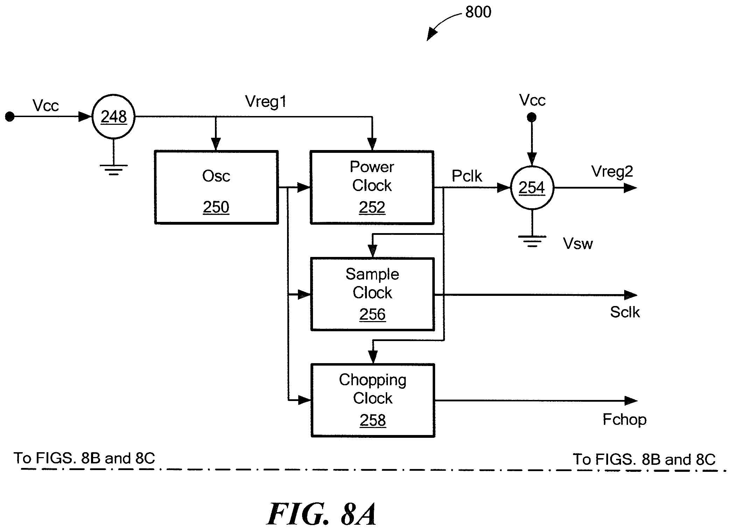

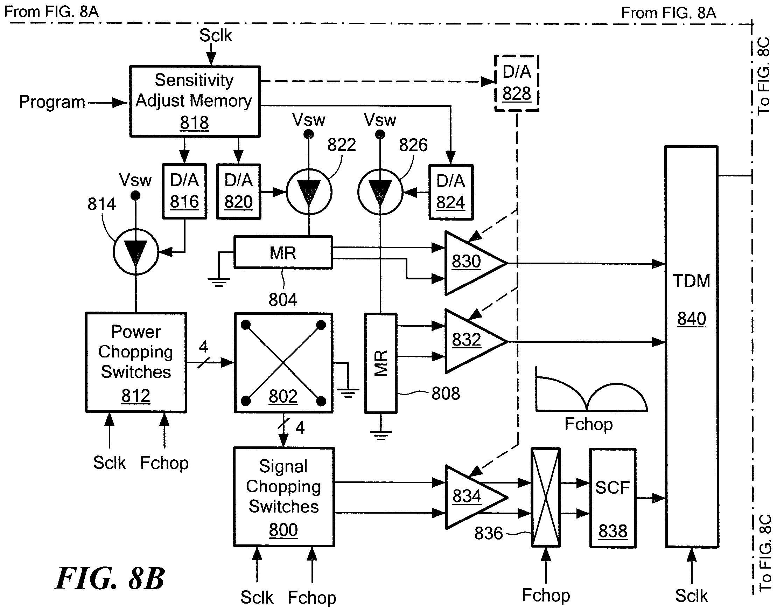

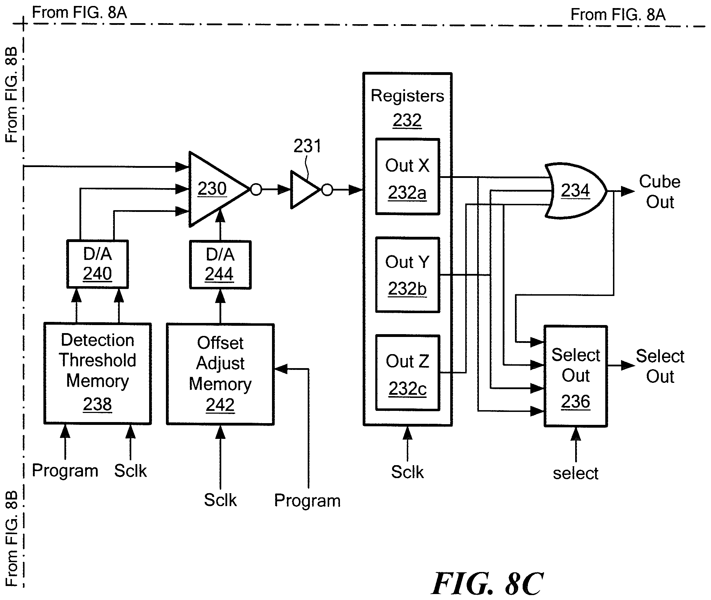

Referring now to FIG. 8, in which like elements of FIG. 2 are shown having like reference designations, an alternate exemplary magnetic field sensor includes a planar Hall element 802. However, in place of the first vertical Hall element 204 and the second vertical Hall element 206, the magnetic field sensor 800 includes a first magnetoresistance circuit 804 and a second magnetoresistance circuit 808. As described above, magnetoresistance elements and circuits tend to have a maximum response axis parallel to a substrate on which they are constructed, in a sense similar to vertical Hall elements.

Magnetoresistance elements and magnetoresistance circuits are not chopped, and thus, the chopping is applied only to the planar Hall element 802.

In order to adjust sensitivities, the magnetic field sensor 800 can include digital-to-analog converters 820, 824 coupled to current sources 822, 826, respectively. The current sources 822, 826 are coupled to drive the magnetoresistance circuits 804, 806, respectively.

The digital-to-analog converters 820, 824 can be coupled to a sensitivity adjust memory 818. The sensitivity just memory 818 can be the same as or similar to the sensitivity adjust memory 216 of FIG. 2. Values stored in the sensitivity adjust memory 818 can adjust sensitivities of the planar Hall element 802, the first magnetoresistance circuit 804, and the second magnetoresistance circuit 808 by way of magnitudes of drive signals provided by the current sources 814, 822, 826, respectively.

Amplifiers 834, 830, 832 are coupled to the planar Hall element 802, the magnetoresistance circuit 804, and the magnetoresistance circuit 808, respectively. In an alternate embodiment, the sensitivity adjust memory 818 can provide sensitivity adjust values to a digital-to-analog converter 828, which can sequentially adjust gains of the amplifiers 834, 830, 832, resulting in a sensitivity adjustment of the magnetic field sensing elements.

A chopping modulator 836 can be the same as or similar to the chopping modulator 226 of FIG. 2. A switched capacitor notch filter 838 can be the same as or similar to the switched capacitor notch filter 228 of FIG. 2.

A time division multiplexing module 840 can be coupled to receive signals from the amplifiers 830, 832 and from the switched capacitor notch filter 838. In operation, by way of a sample clock signal, Sclk, which can be the same as or similar to the sample clock signals of FIGS. 2 and 3, the time division multiplexing module 840 can sequentially select from among the input signals to provide a sequential output signal to the omni comparator 230, which can be the same as or similar to the omni comparator 230 of FIG. 2 and the comparator circuit 435 of FIG. 4.

Other portions of the magnetic field sensor 800 can be the same as or similar to portions of the magnetic field sensor 200 of FIG. 2. However, a chopping clock signal generated by a chopping clock module 868 at the frequency Fchop can be different than the signal 340 of FIG. 3. In particular, for four phase chopping, the signal 340 includes a minimum of twelve chopping pulses, for a minimum of four pulses for each one of three Hall elements in the magnetic field sensor 200 of FIG. 2. In contrast, the magnetic field sensor 800 has only one Hall element, and therefore, a minimum of four chopping clock pulses are needed for four phase chopping.

While four phase chopping as described herein, it will be recognized that chopping can use more than four phases or fewer than four phases, in which case the chopping clocks can have more than the number of pulses shown or fewer than the number of pulses shown, accordingly.

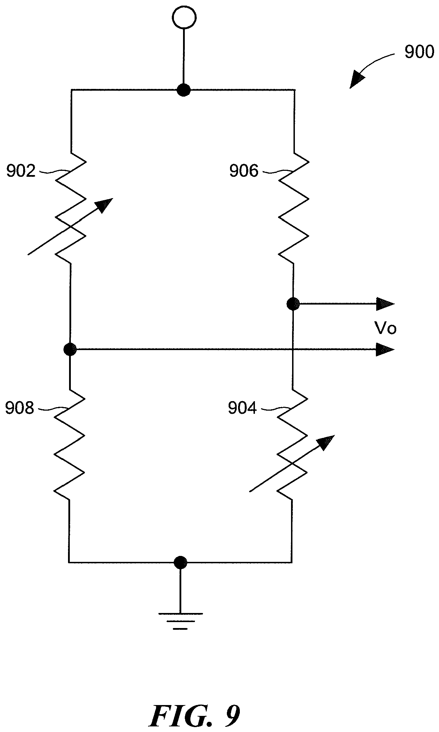

Referring now to FIG. 9, an exemplary magnetoresistance circuit 900 is configured in a bridge arrangement having two magnetoresistance elements 902, 904, and two static resistors 906, 908. The magnetoresistance circuit 900 can be the same as or similar to each one of the magnetoresistance circuits 804, 808 of FIG. 8. To achieve the two magnetoresistance circuits 804, 806, which have maximum response axes pointed along different coordinate axes, the magnetoresistance circuit 900 is merely fabricated a two instances on the substrate with the magnetoresistance elements 902, 904 parallel to each other but at different angles on the substrate.

While one particular form of magnetoresistance circuit 900 is shown, there are many forms of magnetoresistance circuits, in the form of the magnetoresistance circuit can depend on the type of magnetoresistance elements used.

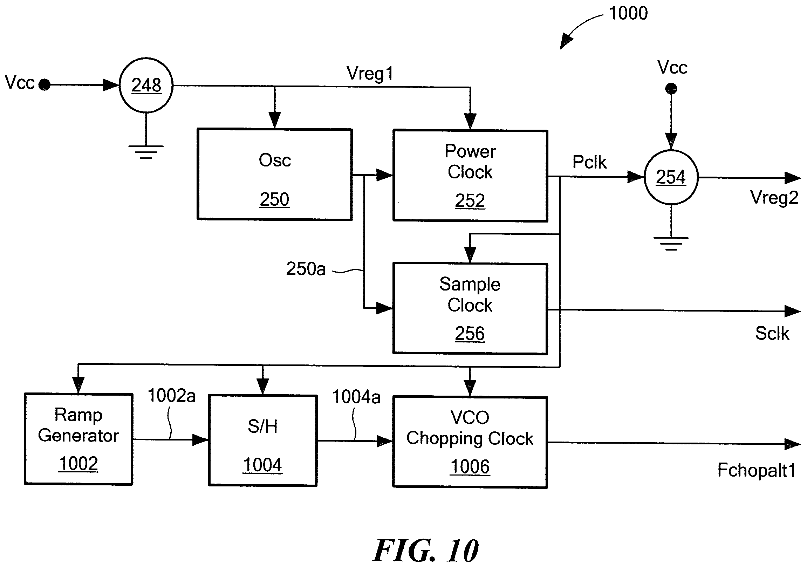

Referring now to FIG. 10, in which like elements of FIGS. 2 and 8 are shown having like reference designations, an alternate exemplary power and clocking circuit 1000 can be used in place of the power and clocking circuit of FIGS. 2 and 8.

The power and clocking circuit can include a ramp generator 1002 that provides a ramp signal 1002a to a sample and hold module 1004. The sample and hold module 1004 provides a sample and hold signal 1004a, which is a sample and held version of the ramp signal 1002a, to a voltage controlled oscillator (VCO) chopping clock module 1006. The voltage controlled chopping clock module 1006 is configured to generate a chopping clock that has a variable frequency Fchopalt1.

In operation, upon each on state (e.g., high state) of the Pclk signal (e.g., a signal 300 of FIG. 3), the sample and hold module 1004 holds a new value of the ramp signal 1002a generated by the ramp generator. Thus, the sampling held signal 1004a can be a step signal that steps upward (and/or downward) causing frequency Fchopalt1 of the chopping signal to step upward (and/or downward) in frequency during each on state of the Pclk signal.

The upward (and/or downward) steps in frequency can be equal steps or unequal steps.

The varying frequency Fchopalt1 has advantages in rejecting possible noise signals that may occur in the magnetic field sensors 200, 800 of FIGS. 2 and 8.

Benefits of having a chopping frequency that changes are described, for example, in U.S. Patent application No. 12/845,115, file July 28, 2010, and entitled "MAGNETIC FIELD SENSOR WITH IMPROVED DIFFERENTIATION BETWEEN A SENSED MAGNETIC FIELD AND A NOISE SIGNAL".

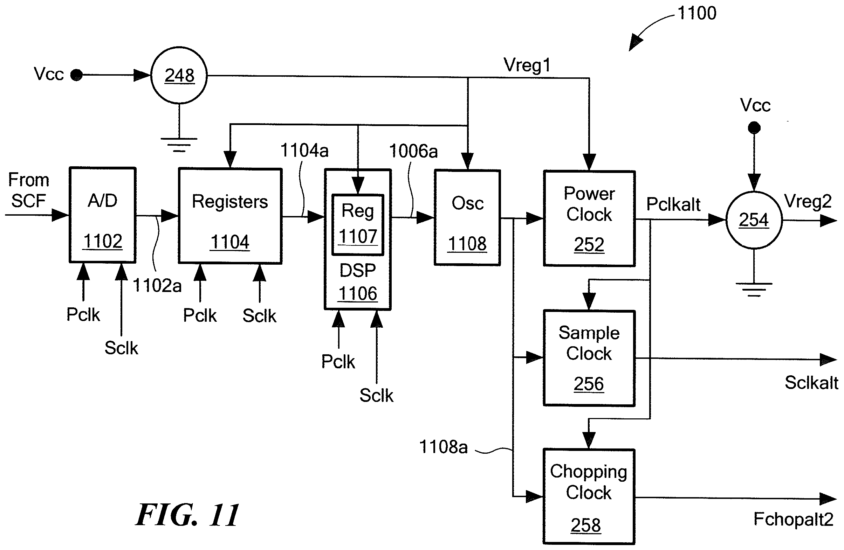

Referring now to FIG. 11, in which like elements of FIGS. 2 and 8 are shown having like reference designations, another alternate exemplary power and clocking circuit 1100 can be used in place of the power and clocking circuit of FIGS. 2 and 8.

The power and clocking circuit 1100 can include an analog-to-digital converter 1102 coupled to receive the signal 228a from the switched capacitor filter 228 of FIG. 2, or alternatively, from the time division multiplex module 840 of FIG. 8.

The analog-to-digital converter 1102 is configured to generate a digital signal 1102a representative of amplitudes of magnetic field signals generated by the three magnetic field sensing elements of FIGS. 2 and 8, i.e., representative of magnetic fields in the three coordinate axes.

The power clocking circuit 1100 can also include registers 1104 coupled to receive and store the digital signal 1102a from a plurality of samples of the signals from the magnetic field sensing elements, i.e., associated with a plurality of the Pclk high states (see, e.g., a signal 300 of FIG. 3).

A digital signal processor 1106 can be coupled to receive the plurality of values 1104a from the registers 1104. The digital signal processor can include registers 1107 that can provide a control signal 1106a that can speed up or slow down an oscillator 1108.

The registers 1104, the registers 1107, and the oscillator 1108 can remain continually powered on by way of the voltage Vreg1.

In operation, the digital signal processor can determine how fast the magnetic field experienced by the magnetic field sensing elements of FIGS. 2 and 8 is changing. According to the rate of change of magnetic field sensed by the digital signal processor, the digital signal processor can cause the oscillator 1108 to generate a clock signal 1108a that can speed up or slow down depending on the sensed rate of change of the magnetic field. Thus, for a faster rate of change of the sensed magnetic field, the oscillator 1108 can cause the PCLK signal, the Sclk signal, and/or the chopping clock signal, with a frequency Fchopalt2, to run faster. Thus, for a fast rate of change of the sensed magnetic field, sampling of the magnetic field sensing elements of FIGS 2 and 8 can achieve a faster sampling rate. Conversely, for a slow rate of change of the sensed magnetic field, sampling of the magnetic field sensing elements of FIGS. 2 and 8 can achieve a slower sampling rate, therefore conserving power.

It should be appreciated that the techniques shown and described above in conjunction with FIGS. 10 and 11 can be used separately, or, in alternate embodiments, the two techniques can be used together.

While FIGS. 1 to 11, focus on changes in a magnetic field in one direction in either in the x-, y- or z-axis, measurements may be taken in a combination of two or more axes. For example, a true three-dimensional magnetic vector amplitude sensor is further described herein that measures magnetic field amplitude in more than one axis. The goal of this sensor is to sense the absolute amplitude (called herein "magnitude") of a magnetic vector in space regardless of the polarity or orientation of the magnetic field. In one example, this type sensor increases sensitivity in detecting magnetic tampering in applications such as smart meters, automated teller machines (ATMs), gambling/gaming devices, electronic locks, and so forth. In applications such as tamper detection in smart meters, the apparent sensitivity is reduced when the applied field is off axis, (i.e., not aligned in either in the x-, y-, or z-axis). The techniques further described herein allow the sensor to sense the true vector amplitude of an external magnetic field. In one example, the techniques described herein determine a vector sum of the three components (or some representation/approximation) and outputs a linear representation of the applied field amplitude and/or applies a threshold and delivers a digital indication of the applied field amplitude. In another example, the output is a signal (e.g., a warning signal) indicating that the magnitude of the magnetic field detected exceeds a threshold value.

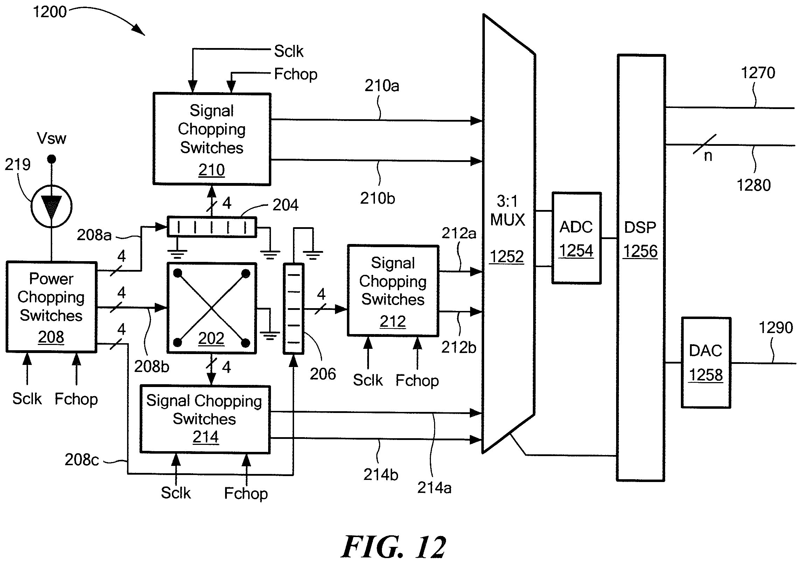

Referring to FIG. 12, a sensor 1200 includes some of the features of FIG. 2, except the sensor 1200 includes a multiplexor 1252 (e.g., 3:1 mux), which includes the functionality of a TDM (e.g., TDM 220) and a chopper. In particular, the multiplexor 1252 receives the three sets of differential signals from the respective Hall elements 202, 204, 206 (e.g., receiving differential signals 210a, 210b, the differential signals 212a, 212b and the differential signals 214a, 214b). The differential signals 210a, 210b in the x-axis are converted to a digital signal by the ADC (analog-to-digital converter) 1254, differential signals 212a, 212b in the y-axis are converted to a digital signal by the ADC 1254 and differential signals 214a, 214b in the z-axis are converted to a digital signal by the ADC 1254.

The DSP (digital signal processor) 1256 provides binary signals 1270 and 1280. In one example, the binary signal 1270 is a warning signal that indicates (e.g., a "1") if the magnitude of the vector sum (

$$\sqrt{B_x^2 + B_y^2 + B_z^2}$$

) is greater than a threshold value corresponding to a particular magnetic field magnitude. In one example, the threshold value may be adjustable (e.g., by a user).

In one example, the binary signals 1280 may be transmitted using an n bit (n>0) signal that indicates the value of the vector sum ( $\sqrt{B_x^2 + B_y^2 + B_z^2}$ ) in binary form.

The DSP 1256 may also output a signal to a DAC (digital-to-analog converter) 1258 and the DAC 1258 outputs a signal 1290, which is an analog signal indicating the value of the vector sum (

$$\sqrt{B_x^2 + B_y^2 + B_z^2}$$

).

In the present invention, instead of taking the sum of the squares and the square root of the sum, the DSP 1256 converts the magnetic signals in the x, y and z directions to digital values and compares them to a table which indicates if the x, y, and z coordinates relate to a point outside of a predetermined shape, for example a sphere. In some examples, where only two coordinate axes are used, the DSP converts the magnetic signals to digital values and compares them to a table which indicates if the coordinates relate to a point outside of a circle. In further examples, the lookup table methodology is not limited to "circles" or "spheres" but can be used to implement any arbitrary or predetermined response desired. Furthermore, in the present invention, a threshold varies as a function of the phase of the resultant vector and therefore may describe any shape in 2D or 3D space.

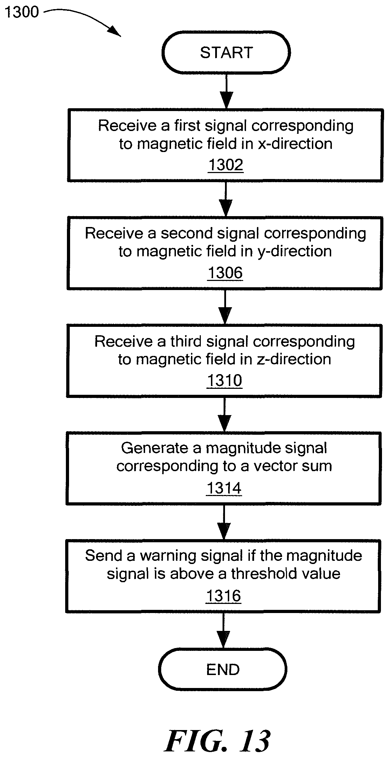

Referring to FIG. 13, a process 1300 is an example of a process to determine if a magnitude of a magnetic field is greater than a threshold voltage. Process 1300 receives a first signal corresponding to magnetic field in x-direction (1302). For example, the vertical Hall element 202 generates a first magnetic field signal (e.g., differential signals 210a, 210b) that is received by the processor 1202 after chopping.

Process 1300 receives a second signal corresponding to magnetic field in y-direction (1306). For example, the vertical Hall element 204 generates a second magnetic field signal (e.g., differential signals 212a, 212b) that is received by the processor 1202 after chopping.

Process 1300 receives a third signal corresponding to magnetic field in z-direction (1310). For example, the planar Hall element 202 generates a second magnetic field signal (e.g., differential signals 214a, 214b) that is received by the processor 1202.

Process 1300 generates a magnitude signal corresponding to the vector sum (1314). For example, the processor 1202 generates a magnitude signal 1210 corresponding to the vector sum of the first, second and third magnetic field signals.

Process 1300 sends a warning signal if the magnitude signal is above a threshold (1316). For example, the magnitude signal 1210 is sent to a comparator 1220 to compare the signal to a signal 1216 corresponding to a magnetic field threshold value. If the magnitude signal 1210 exceeds the signal 1216 a warning signal 1230 is generated.

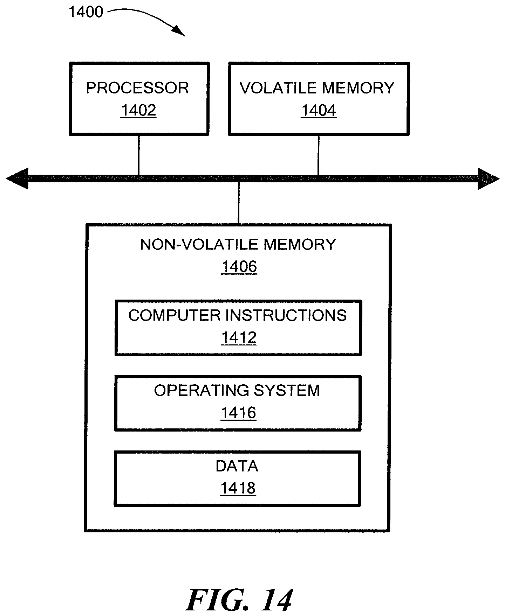

Referring to FIG. 14, in one example, a computing device 1400 includes a processor 1402, a volatile memory 1404 and a non-volatile memory 1406 (e.g., hard disk). The non-volatile memory 1406 stores computer instructions 1412, an operating system 1416 and data 1418. In one example, the computer instructions 1412 are executed by the processor 1402 out of volatile memory 1404 to perform all or part of the processes described herein (e.g., process 1300).

The processes described herein (e.g., process 1300) are not limited to use with the hardware and software of FIG. 14; they may find applicability in any computing or processing environment and with any type of machine or set of machines that is capable of running a computer program. The processes described herein may be implemented in hardware, software, or a combination of the two.

The processes described herein are not limited to the specific examples described. For example, one of ordinary skill in the art would recognize that the techniques described herein may be used using only two of the three Cartesian axes. In other examples, the process 1300 is not limited to the specific processing order of FIG. 13. Rather, any of the processing blocks of FIG. 13 is combined or removed, performed in parallel or in serial, as necessary, to achieve the results set forth above and as long as the method comprises at least the steps as defined in the corresponding independent claim.

The processing blocks (for example, in the process 1300) associated with implementing the system may be performed by one or more programmable processors executing one or more computer programs to perform the functions of the system. All or part of the system may be implemented as, special purpose logic circuitry (e.g., an FPGA (field-programmable gate array) and/or an ASIC (application-specific integrated circuit)). All or part of the system may be implemented using electronic hardware circuitry that include electronic devices such as, for example, at least one of a processor, a memory, a programmable logic device or a logic gate.

Elements of different embodiments described herein may be combined to form other embodiments not specifically set forth above, as long as those embodiments include at least the features of the corresponding independent claim.

Various elements, which are described in the context of a single embodiment, may also be provided separately or in any suitable subcombination. Said other embodiments not specifically described herein are also within the scope of the following claims.

**Claims**

1. A magnetic field sensor (200), comprising:

   first and second magnetic field sensing elements having respective first and second maximum response axes, the first and second maximum response axes pointing along respective first and second different coordinate axes, wherein, in response to a magnetic field, the first and second magnetic field sensing elements are operable to generate first and second magnetic field signals; and
   an electronic circuit coupled to receive the first and the second magnetic field signals, wherein the electronic circuit is configured to:

      determine a vector having first and second vector components in accordance with the first and the second magnetic field signals; and
      use the first and second vector components to look up respective first and second vector component values in a table to determine if the vector is outside a predetermined shape, **characterized in that**:
      the vector being outside the predetermined shape is indicated by a magnitude of the vector exceeding a threshold which varies as a function of a phase of the vector.

2. The magnetic field sensor (200) of claim 1, wherein the predetermined shape comprises a circle.

3. The magnetic field sensor (200) of claim 1, wherein the first magnetic field sensing element comprises a planar Hall element (202) and the second magnetic field sensing element comprises a first vertical Hall element (204).

4. The magnetic field sensor (200) of claim 1, wherein the first magnetic field sensing element comprises a first vertical Hall element (204) and the second magnetic field sensing element comprises a second vertical Hall element (206).

5. The magnetic field sensor (200) of claim 1, wherein the first magnetic field sensing element comprises a planar Hall element (202) and the second magnetic field sensing element comprises a magnetoresistance circuit (804).

6. The magnetic field sensor (200) of claim 1, wherein the first magnetic field sensing element comprises a first magnetoresistance circuit (804) and the second magnetic field sensing element comprises a second magnetoresistance circuit (808).

7. The magnetic field sensor (200) of Claim 1, further comprising: a third magnetic field sensing element having a third maximum response axis, the first, second and third maximum response axes pointing along the first, the second, and a third different coordinate axis orthogonal to the first and second axes, wherein, in response to a magnetic field, the first, second, and third magnetic field sensing elements are operable to generate first, second, and third magnetic field signals,
   wherein the electronic circuit is configured to:

      determine the vector having the first and second vector components and a third vector component according to the first, the second, and the third magnetic field signals, and
      use the first, second, and third vector components to look up the respective first and second vector component values and also a respective third vector component value in a table to determine if the vector is outside a predetermined sphere.

8. The magnetic field sensor (200) of claim 7, wherein the first magnetic field sensing element comprises a planar Hall element (202), the second magnetic field sensing element comprises a first vertical Hall element (204), and the third magnetic field sensing element comprises a second vertical Hall element (206).

9. The magnetic field sensor (200) of claim 7, wherein the first magnetic field sensing element comprises a planar Hall element (202), the second magnetic field sensing element comprises a first magnetoresistance circuit (804), and the third magnetic field sensing element comprises a second magnetoresistance circuit (808).

10. The magnetic field sensor of claim 1 or 7, wherein the electronic circuit is further configured to provide a warning signal if the magnitude of the vector exceeds the threshold value.

11. The magnetic field sensor of claim 1 or 10, wherein the electronic circuit is further configured to provide a signal indicating the magnitude of the vector.

12. The magnetic field sensor of claim 1 or 7, wherein the electronic circuit is further configured to provide one or more signals indicating the magnitude of the vector exceeding an adjustable threshold.

13. A method comprising:

receiving a first magnetic field signal from a first magnetic field sensing element; receiving a second magnetic field signal from a second magnetic field sensing element, the first and second magnetic field sensing elements having respective first and second maximum response axes, the first second and second maximum response axes pointing along respective first and second different coordinate axes, wherein, in response to a magnetic field, the first and second magnetic field sensing elements are operable to generate the first and the second magnetic field signals; wherein the method further comprises:

determining a vector having first and second vector components according to the first and the second magnetic field signals; and using the first and second vector components to look up respective first and second vector component values in a table to determine if the vector is outside a predetermined shape, **characterized in that**: the vector being outside the predetermined shape is indicated by a magnitude of the vector exceeding a threshold which varies as a function of a phase of the vector.

14. The method of claim 13, further comprising receiving a third magnetic field signal from a third magnetic field sensing element, wherein the third magnetic field sensing element has a third maximum response axis, the third maximum response axis pointing along a respective the third different coordinate axis orthogonal to the first and second coordinate axes, wherein, in response to a magnetic field, the third magnetic field sensing element is operable to generate the third magnetic field signal, wherein the determining the vector comprises determining the vector having the first and second vector components and a third vector component according to the first, the second, and the third magnetic field signals, and wherein the using the first and second vector components comprises: using the first, second, and third vector components to look up the respective first and second vector component values and also a respective third vector component value in the table to determine if the vector is indicative of the vector being outside a predetermined sphere.

15. The method of claim 14, wherein the first magnetic field sensing element comprises a planar Hall element (202),

wherein the second magnetic field sensing element comprises first vertical Hall element (204), and wherein the third magnetic field sensing element comprises a second vertical Hall element (206).

16. The method of claim 14, further comprising providing a warning signal if the magnitude of the vector exceeds the threshold value.

17. The method of claim 16, wherein the threshold value is adjustable by a user.

18. The method of claim 14 or 16, further comprising providing a signal indicating the magnitude of the vector.

19. The method of Claim 13, wherein the predetermined shape comprises a circle.

**Patentansprüche**

1. Magnetfeldsensor (200), umfassend:

ein erstes und zweites Magnetfeldsensorelement, das eine entsprechende erste und zweite maximale Ansprechachse aufweist, wobei die erste und zweite maximale Ansprechachse entlang einer entsprechenden ersten und zweiten unterschiedlichen Koordinatenachse ausgerichtet sind, wobei das erste und zweite Magnetfeldsensorelement in Reaktion auf ein Magnetfeld dazu betriebsfähig sind, ein erstes und zweites Magnetfeldsignal zu erzeugen; und eine elektronische Schaltung, die so gekoppelt ist, dass sie das erste und das zweite Magnetfeldsignal empfängt, wobei die elektronische Schaltung konfiguriert ist zum:

Ermitteln eines Vektors, der eine erste und zweite Vektorkomponente gemäß dem ersten und zweiten Magnetfeldsignal aufweist; und Verwenden der ersten und zweiten Vektorkomponente, um einen entsprechenden ersten und zweiten Vektorkomponentenwert in einer Tabelle zu suchen, um zu ermitteln, ob der Vektor außerhalb einer vorbestimmten Form liegt, **dadurch gekennzeichnet, dass**:

die Tatsache, dass der Vektor außerhalb der vorbestimmten Form liegt, dadurch angegeben wird, dass eine Größe des Vektors einen Schwellenwert überschreitet, der als Funktion einer Phase des Vektors variiert.

2. Magnetfeldsensor (200) nach Anspruch 1, wobei die vorbestimmte Form einen Kreis umfasst.

3. Magnetfeldsensor (200) nach Anspruch 1, wobei das erste Magnetfeldsensorelement ein planares Hall-Element (202) umfasst und das zweite Magnetfeldsensorelement ein vertikales Hall-Element (204) umfasst.

4. Magnetfeldsensor (200) nach Anspruch 1, wobei das erste Magnetfeldsensorelement ein erstes vertikales Hall-Element (204) umfasst und das zweite Magnetfeldsensorelement ein zweites vertikales Hall-Element (206) umfasst.

5. Magnetfeldsensor (200) nach Anspruch 1, wobei das erste Magnetfeldsensorelement ein planares Hall-Element (202) umfasst und das zweite Magnetfeldsensorelement eine magnetoresistive Schaltung (804) umfasst.

6. Magnetfeldsensor (200) nach Anspruch 1, wobei das erste Magnetfeldsensorelement eine erste magnetoresistive Schaltung (804) umfasst und das zweite Magnetfeldsensorelement eine zweite magnetoresistive Schaltung (808) umfasst.

7. Magnetfeldsensor (200) nach Anspruch 1, ferner umfassend: ein drittes Magnetfeldsensorelement mit einer dritten maximalen Ansprechachse, wobei die erste, zweite und dritte maximale Ansprechachse entlang der ersten, der zweiten und einer dritten, davon verschiedenen Koordinatenachse orthogonal zu der ersten und der zweiten Achse ausgerichtet sind, wobei in Reaktion auf ein Magnetfeld das erste, zweite und dritte Magnetfeldsensorelement betriebsfähig sind, um ein erstes, zweites und drittes Magnetfeldsignal zu erzeugen, wobei die elektronische Schaltung konfiguriert ist zum:

Ermitteln des Vektors, der die erste und zweite Vektorkomponente und eine dritte Vektorkomponente gemäß dem ersten, zweiten und dritten Magnetfeldsignal aufweist; und Verwenden der ersten, zweiten und dritten Vektorkomponente, um den entsprechenden ersten und zweiten Vektorkomponentenwert sowie auch einen entsprechenden dritten Vektorkomponentenwert in einer Tabelle zu suchen, um zu ermitteln, ob der Vektor außerhalb einer vorbestimmten Sphäre liegt.

8. Magnetfeldsensor (200) nach Anspruch 7, wobei das erste Magnetfeldsensorelement ein planares Hall-Element (202) umfasst, das zweite Magnetfeldsensorelement ein erstes vertikales Hall-Element (204) umfasst und das dritte Magnetfeldsensorelement ein zweites vertikales Hall-Element (206) umfasst.

9. Magnetfeldsensor (200) nach Anspruch 7, wobei das erste Magnetfeldsensorelement ein planares Hall-Element (202) umfasst, das zweite Magnetfeldsensorelement eine erste magnetoresistive Schaltung (804) umfasst und das dritte Magnetfeldsensorelement eine zweite magnetoresistive Schaltung (808) umfasst.

10. Magnetfeldsensor nach Anspruch 1 oder 7, wobei die elektronische Schaltung ferner so konfiguriert ist, dass sie ein Warnsignal bereitstellt, wenn die Größe des Vektors den Schwellenwert überschreitet.

11. Magnetfeldsensor nach Anspruch 1 oder 10, wobei die elektronische Schaltung ferner so konfiguriert ist, dass sie ein Signal bereitstellt, das die Größe des Vektors angibt.

12. Magnetfeldsensor nach Anspruch 1 oder 7, wobei die elektronische Schaltung ferner so konfiguriert ist, dass sie ein oder mehrere Signale bereitstellt, die angeben, dass die Größe des Vektors einen anpassbaren Schwellenwert überschreitet.

13. Verfahren, umfassend:

Empfangen eines ersten Magnetfeldsignals von einem ersten Magnetfeldsensorelement; Empfangen eines zweiten Magnetfeldsignals von einem zweiten Magnetfeldsensorelement, wobei das erste und zweite Magnetfeldsensorelement eine entsprechende erste und zweite maximale Ansprechachse aufweisen, wobei die erste und zweite maximale Ansprechachse entlang einer entsprechenden ersten und zweiten unterschiedlichen Koordinatenachse ausgerichtet sind, wobei das erste und zweite Magnetfeldsensorelement in Reaktion auf ein Magnetfeld dazu betriebsfähig sind, das erste und zweite Magnetfeldsignal zu erzeugen; wobei das Verfahren ferner umfasst:

Ermitteln eines Vektors, der eine erste und zweite Vektorkomponente gemäß dem ersten und zweiten Magnetfeldsignal aufweist; und

Verwenden der ersten und zweiten Vektorkomponente, um einen entsprechenden ersten und zweiten Vektorkomponentenwert in einer Tabelle zu suchen, um zu ermitteln, ob der Vektor außerhalb einer vorbestimmten Form liegt, **dadurch gekennzeichnet, dass**:

die Tatsache, dass der Vektor außerhalb der vorbestimmten Form liegt, dadurch angegeben wird, dass eine Größe des Vektors einen Schwellenwert überschreitet, der als Funktion einer Phase des Vektors variiert.

14. Verfahren nach Anspruch 13, ferner umfassend das Empfangen eines dritten Magnetfeldsignals von einem dritten Magnetfeldsensorelement, wobei das dritte Magnetfeldsensorelement eine dritte maximale Ansprechachse aufweist, wobei die dritte maximale Ansprechachse entlang einer entsprechenden dritten unterschiedlichen Koordinatenachse orthogonal zu der ersten und der zweiten Koordinatenachse ausgerichtet ist, wobei das dritte Magnetfeldsensorelement in Reaktion auf ein Magnetfeld betriebsfähig ist, um das dritte Magnetfeldsignal zu erzeugen, wobei das Ermitteln des Vektors das Ermitteln des Vektors umfasst, der die erste und zweite Vektorkomponente und eine dritte Vektorkomponente gemäß dem ersten, dem zweiten und dem dritten Magnetfeldsignal aufweist, und wobei das Verwenden der ersten und zweiten Vektorkomponente Folgendes umfasst:

Verwenden der ersten, zweiten und dritten Vektorkomponente, um den entsprechenden ersten und zweiten Vektorkomponentenwert sowie auch einen entsprechenden dritten Vektorkomponentenwert in der Tabelle zu suchen, um zu ermitteln, ob der Vektor angibt, dass der Vektor außerhalb einer vorbestimmten Sphäre liegt.

15. Verfahren nach Anspruch 14, wobei das erste Magnetfeldsensorelement ein planares Hall-Element (202) umfasst,

wobei das zweite Magnetfeldsensorelement ein erstes vertikales Hall-Element (204) umfasst; und
wobei das dritte Magnetfeldsensorelement ein zweites vertikales Hall-Element (206) umfasst.

16. Verfahren nach Anspruch 14, ferner umfassend das Bereitstellen eines Warnsignals, wenn die Größe des Vektors den Schwellenwert überschreitet.

17. Verfahren nach Anspruch 16, wobei der Schwellenwert durch einen Benutzer anpassbar ist.

18. Verfahren nach Anspruch 14 oder 16, ferner umfassend das Bereitstellen eines Signals, das die Größe des Vektors angibt.

19. Verfahren nach Anspruch 13, wobei die vorbestimmte Form einen Kreis umfasst.

**Revendications**

1. Capteur de champ magnétique (200), comprenant :

des premier et deuxième éléments de captage de champ magnétique ayant des premier et deuxième axes de réponse maximale respectifs, les premier et deuxième axes de réponse maximale pointant le long des premier et deuxième axes de coordonnées différents respectifs, dans lequel, en réponse à un champ magnétique, les premier et deuxième éléments de captage de champ magnétique sont fonctionnels pour générer des premier et deuxième signaux de champ magnétique ; et
un circuit électronique couplé pour recevoir les premier et deuxième signaux de champ magnétique,
dans lequel le circuit électronique est configuré pour :

déterminer un vecteur ayant des première et deuxième composantes de vecteur conformément aux premier et deuxième signaux de champ magnétique ; et
utiliser les première et deuxième composantes de vecteur pour consulter des première et deuxième valeurs de composantes de vecteur respectives dans une table afin de déterminer si le vecteur est en dehors d'une forme prédéterminée, **caractérisé en ce que** :
le fait que le vecteur est en dehors de la forme prédéterminée est indiqué par une grandeur du vecteur dépassant un seuil qui varie en fonction d'une phase du vecteur.

2. Capteur de champ magnétique (200) selon la revendication 1, dans lequel la forme prédéterminée comprend un cercle.

3. Capteur de champ magnétique (200) selon la revendication 1, dans lequel le premier élément de captage de champ magnétique comprend un élément à effet Hall plan (202) et le deuxième élément de captage de champ magnétique comprend un premier élément à effet Hall vertical (204).

**4.** Capteur de champ magnétique (200) selon la revendication 1, dans lequel le premier élément de captage de champ magnétique comprend un premier élément à effet Hall vertical (204) et le deuxième élément de captage de champ magnétique comprend un deuxième élément à effet Hall vertical (206).

**5.** Capteur de champ magnétique (200) selon la revendication 1, dans lequel le premier élément de captage de champ magnétique comprend un élément à effet Hall plan (202) et le deuxième élément de captage de champ magnétique comprend un circuit à magnétorésistance (804).

**6.** Capteur de champ magnétique (200) selon la revendication 1, dans lequel le premier élément de captage de champ magnétique comprend un premier circuit à magnétorésistance (804) et le deuxième élément de captage de champ magnétique comprend un deuxième circuit à magnétorésistance (808).

**7.** Capteur de champ magnétique (200) selon la revendication 1, comprenant en outre : un troisième élément de captage de champ magnétique ayant un troisième axe de réponse maximale, les premier, deuxième et troisième axes de réponse maximale pointant le long du premier axe, du deuxième axe et d'un troisième axes de coordonnées différent orthogonal aux premier et deuxième axes, dans lequel, en réponse à un champ magnétique, les premier, deuxième et troisième éléments de captage de champ magnétique sont fonctionnels pour générer des premier, deuxième et troisième signaux de champ magnétique, dans lequel le circuit électronique est configuré pour :

déterminer le vecteur ayant les première et deuxième composantes de vecteur et une troisième composante de vecteur selon les premier, deuxième et troisième signaux de champ magnétique, et

utiliser les première, deuxième et troisième composantes vectorielles pour consulter les première et deuxième valeurs de composantes de vecteur respectives ainsi qu'une troisième valeur de composante de vecteur respective dans une table afin de déterminer si le vecteur est en dehors d'une sphère prédéterminée.

**8.** Capteur de champ magnétique (200) selon la revendication 7, dans lequel le premier élément de captage de champ magnétique comprend un élément à effet Hall plan (202), le deuxième élément de captage de champ magnétique comprend un premier élément à effet Hall vertical (204), et le troisième élément de captage de champ magnétique comprend un deuxième élément à effet Hall vertical (206).

**9.** Capteur de champ magnétique (200) selon la revendication 7, dans lequel le premier élément de captage de champ magnétique comprend un élément à effet Hall plan (202), le deuxième élément de captage de champ magnétique comprend un premier circuit à magnétorésistance (804), et le troisième élément de captage de champ magnétique comprend un deuxième circuit à magnétorésistance (808).

**10.** Capteur de champ magnétique selon la revendication 1 ou 7, dans lequel le circuit électronique est en outre configuré pour fournir un signal d'avertissement si la grandeur du vecteur dépasse la valeur de seuil.

**11.** Capteur de champ magnétique selon la revendication 1 ou 10, dans lequel le circuit électronique est en outre configuré pour fournir un signal indiquant la grandeur du vecteur.

**12.** Capteur de champ magnétique selon la revendication 1 ou 7, dans lequel le circuit électronique est en outre configuré pour fournir un ou plusieurs signaux indiquant la grandeur du vecteur dépassant un seuil réglable.

**13.** Procédé comprenant :

la réception d'un premier signal de champ magnétique à partir d'un premier élément de captage de champ magnétique ;
la réception d'un deuxième signal de champ magnétique à partir d'un deuxième élément de captage de champ magnétique, les premier et deuxième éléments de captage de champ magnétique ayant des premier et deuxième axes de réponse maximale respectifs, les premier et deuxième axes de réponse maximale pointant le long de premier et deuxième axes de coordonnées différents respectifs, dans lequel, en réponse à un champ magnétique, les premier et deuxième éléments de captage de champ magnétique sont fonctionnels pour générer les premier et deuxième signaux de champ magnétique ;
dans lequel le procédé comprend en outre :

la détermination d'un vecteur ayant des première et deuxième composantes de vecteur selon les premier et deuxième signaux de champ magnétique ; et
l'utilisation des première et deuxième composantes de vecteur pour consulter des première et deuxième valeurs de composantes de vecteur respectives dans une table afin de déterminer si le vecteur est en dehors d'une forme prédéterminée, **caractérisé en ce que** :

le fait que le vecteur est en dehors de la forme prédéterminée est indiqué par une grandeur du vecteur dépassant un seuil qui varie en fonction d'une phase du vecteur.

14. Procédé selon la revendication 13, comprenant en outre la réception d'un troisième signal de champ magnétique à partir d'un troisième élément de captage de champ magnétique, dans lequel le troisième élément de captage de champ magnétique a un troisième axe de réponse maximale, le troisième axe de réponse maximale pointant le long d'un troisième axe de coordonnées différent respectif orthogonal aux premier et deuxième axes de coordonnées, dans lequel, en réponse à un champ magnétique, le troisième élément de captage de champ magnétique est fonctionnel pour générer le troisième signal de champ magnétique,
dans lequel la détermination du vecteur comprend la détermination du fait que le vecteur a les première et deuxième composantes de vecteur et une troisième composante de vecteur selon les premier, deuxième et troisième signaux de champ magnétique, et dans lequel l'utilisation des première et deuxième composantes de vecteur comprend :
l'utilisation des première, deuxième et troisième composantes de vecteur pour consulter les première et deuxième valeurs de composante de vecteur respectives ainsi qu'une troisième valeur de composante de vecteur respective dans la table afin de déterminer si le vecteur est indicatif du fait que le vecteur est en dehors d'une sphère prédéterminée.

15. Procédé selon la revendication 14, dans lequel le premier élément de captage de champ magnétique comprend un élément à effet Hall plan (202),

dans lequel les premier et deuxième éléments de captage de champ magnétique comprennent un premier élément à effet Hall vertical (204), et dans lequel le troisième élément de captage de champ magnétique comprend un deuxième élément à effet Hall vertical (206) .

16. Procédé selon la revendication 14, comprenant en outre la fourniture d'un signal d'avertissement si la grandeur du vecteur dépasse la valeur seuil.

17. Procédé selon la revendication 16, dans lequel la valeur seuil est réglable par un utilisateur.

18. Procédé selon la revendication 14 ou 16, comprenant en outre la fourniture d'un signal indiquant la grandeur du vecteur.

19. Procédé selon la revendication 13, dans lequel la forme prédéterminée comprend un cercle.

**FIG. 1**

**FIG. 2**

Vcc ●————→ (248)———————— Vreg1 ——————┐

Vcc
●
│
▼

┌──────────┐        ┌──────────┐
│   Osc    │───────→│  Power   │── Pclk ──→ (254) ── Vreg2 ──→
│          │        │  Clock   │
│   250    │        │   252    │
└──────────┘        └──────────┘
                         │
                         ▼
                    ┌──────────┐
                    │  Sample  │
                    │  Clock   │────────── Sclk ──────→
                    │   256    │
                    └──────────┘
     250a                │
                         ▼
                    ┌──────────┐
                    │ Chopping │
                    │  Clock   │────────── Fchop ─────→
                    │   258    │
                    └──────────┘

200

*FIG. 2A*

From FIG. 2A

To FIG. 2C

To FIG. 2C

From FIG. 2A

**Sensitivity Adjust Memory 216** — Sclk, Sclk, Fchop

**D/A 218**

**D/A 224**

**Signal Chopping Switches 210** — Sclk, Fchop

**TDM 220** — Sclk

**222** (amplifier) — 220a, 220b, 222a, 222b, 224a

**Signal Chopping Switches 212** — Sclk, Fchop — 212a, 212b

**Signal Chopping Switches 214** — Sclk, Fchop — 214a, 214b

**Power Chopping Switches 208** — Sclk, Fchop — 208a, 208b, 208c

**202** — **204** — **206**

Vsw — 219 — 218a

216a, 216b, 210a, 210b

Program

4

*FIG. 2B*

*FIG. 2C*

*FIG. 3*

EP 3 338 103 B1

**FIG. 4**

$V_{OUT}$

$V_{HIGH}$

$V_{LOW}$

$-V_{IN}$ (VOLTS)

$+V_{IN}$ (VOLTS)

$-V_{TL+}$   $-V_{TL-}$   $V_{TH-}$   $V_{TH+}$

*FIG. 5*

**FIG. 6**

Vdd

Xout

ORout

Yout

Zout

**FIG. 7**

| FIG. 8A | |
|---|---|
| FIG. 8B | FIG. 8C |

**FIG. 8**

*FIG. 8A*

Sclk

Program →

Sensitivity
Adjust Memory
818

Vsw

Vsw

D/A
828

822

826

Vsw

D/A
816

D/A
820

D/A
824

814

MR

804

830

TDM

840

Power
Chopping
Switches
812

4

802

4

MR

808

832

Sclk   Fchop

Fchop

Signal
Chopping
Switches
800

834

836

SCF

838

Sclk   Fchop

Fchop

Sclk

*FIG. 8B*

EP 3 338 103 B1

To FIG. 8C

To FIG. 8C

From FIG. 8A ⋯⋯⋯⋯⋯⋯⋯⋯⋯⋯⋯⋯⋯⋯⋯⋯⋯ From FIG. 8A ⋯⋯⋯

From FIG. 8B

**Registers**
**232**

231

Out X
**232a**

230

234 → Cube Out

D/A
**240**

D/A
**244**

Out Y
**232b**

Detection Threshold Memory **238**

Offset Adjust Memory **242**

Out Z
**232c**

Select Out **236** → Select Out

Program   Sclk

Sclk

Sclk   Program

Sclk

select

From FIG. 8B

*FIG. 8C*

**FIG. 9**

**FIG. 10**

FIG. 11

EP 3 338 103 B1

1270

1280

/ n

1290

DAC
1258

DSP 1256

ADC
1254

3:1
MUX
1252

Signal Chopping Switches 212

212a

212b

Sclk Fchop

210a

210b

Sclk Fchop

Signal Chopping Switches 210

204

4

206

4

202

4

Signal Chopping Switches 214

214a

214b

Fchop

Sclk

208a

4

208b

4

208c

Power Chopping Switches 208

Sclk Fchop

Vsw

219

1200

*FIG. 12*

1300

```
        START

Receive a first signal corresponding
   to magnetic field in x-direction
              1302

Receive a second signal corresponding
    to magnetic field in y-direction
               1306

 Receive a third signal corresponding
    to magnetic field in z-direction
               1310

      Generate a magnitude signal
    corresponding to a vector sum
               1314

Send a warning signal if the magnitude
   signal is above a threshold value
              1316

         END
```

*FIG. 13*

1400

| PROCESSOR | VOLATILE MEMORY |
| 1402 | 1404 |

NON-VOLATILE MEMORY
1406

COMPUTER INSTRUCTIONS
1412

OPERATING SYSTEM
1416

DATA
1418

*FIG. 14*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 27721814
- US 61827280
- US 2011031968 A1
- US 2014347044 A1
- US 09537111
- US 76634113
- US 7990209 B
- US 84511510